Europäisches Patentamt

European Patent Office

Office européen des brevets

(11) Publication number: **0 063 915**
**B1**

(12) EUROPEAN PATENT SPECIFICATION

(45) Date of publication of patent specification: **27.11.85**

(21) Application number: **82302041.7**

(22) Date of filing: **21.04.82**

(51) Int. Cl.⁴: **H 01 L 29/78**

(54) A metal insulator semiconductor transistor.

(30) Priority: **24.04.81 JP 62161/81**

(43) Date of publication of application:
**03.11.82 Bulletin 82/44**

(45) Publication of the grant of the patent:
**27.11.85 Bulletin 85/48**

(84) Designated Contracting States:
**DE FR GB NL**

(56) References cited:
**US-A-3 470 610**
**US-A-4 163 984**

(73) Proprietor: **FUJITSU LIMITED**
**1015, Kamikodanaka Nakahara-ku**
**Kawasaki-shi Kanagawa 211 (JP)**

(72) Inventor: **Sakurai, Junji**
**7-11 Seta 4-chome**
**Setagaya-ku Tokyo (JP)**

(74) Representative: **Rackham, Stephen Neil et al**
**GILL JENNINGS & EVERY 53-64 Chancery Lane**
**London WC2A 1HN (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

The present invention relates to a metal insulator semiconductor (MIS) field effect transistor (FET) formed on an insulator.

One type of MISFET formed on an insulator is a silicon on sapphire metal oxide silicon (SOSMOS) transistor described for example in an article by Alan Capell et al., entitled "Process Refinements Bring C-MOS on Sapphire into Commercial Use", published in Electronics, May 26, 1977, pp 99—105. In SOSMOS transistors, since the sapphire acts as an insulating substrate, the parasitic capacitances between the source and the substrate, between the drain and the substrate and between the conductor lines and the substrate are small. Therefore, the switching speed of integrated circuits (IC) composed of SOSMOS transistors is higher than that of IC's composed of MOS transistors built in a bulk silicon substrate.

Another MISFET formed on an insulator is a silicon on insulating substrate (SOIS) type transistor. In this case, a silicon epitaxial layer lies on an insulating layer of silicon dioxide or silicon nitride, and an MIS transistor is built in a silicon layer deposited on the insulating layer.

Since the high-frequency properties of an MIS transistor can be improved by shortening the channel length, MIS transistors having a short channel length of 2 μm or less, the so-called short channel MIS transistors, are produced. However, these devices include some problems, in that feedback occurs between the potential applied to the drain electrode and the conduction through the channel. Also variations of the potential applied to the drain electrode lower the transconductance and punch through voltage of the transistor.

According to this invention there is provided a metal insulator semiconductor transistor comprising an insulating layer; a semiconductor layer which is formed on the insulating layer and comprises a source region, a drain region and a channel region; a gate insulating layer formed on the channel region; and a gate electrode formed on the gate insulating layer; the portion of the insulating layer lying beneath the channel region being thinner than that lying beneath the other regions and this thinner portion contributing to the distribution of equipotential lines in the channel region parallel to the gate electrode, and a conducting layer being formed beneath the insulating layer.

An advantage of a transistor in accordance with the present invention is the reduction of the feedback influencing the channel of a short channel MISFET on an insulator and the prevention of the reduction in the transconductance and punchthrough voltage.

The portions of the insulating layer lying under the source and drain regions, are thick, so that the parasitic capacitances between the conductor layer and the source and drain regions are small, whereas the portion of the insulating layer under the channel region is thin, so that the grounded conducting layer influences the equipotential lines in the channel region to be substantially parallel with the gate electrode of the MISFET.

A transistor in accordance with the present invention will now be described and contrasted with the prior art with reference to the accompanying drawings, in which:—

Figure 1 is a diagrammatic section through a conventional MISFET formed on an insulating substrate;

Figure 2 is a diagrammatic section through an MISFET in accordance with the present invention; and,

Figure 3A to 3H are diagrammatic sections through an MISFET transistor in accordance with the present invention at various stages of its production.

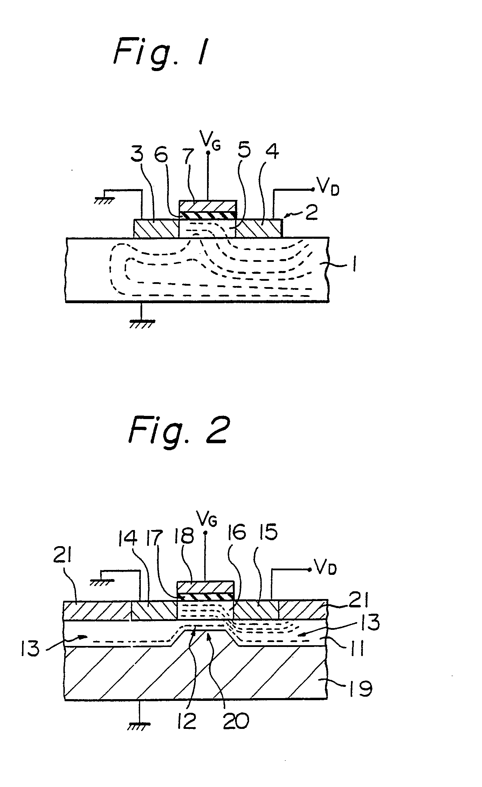

Figure 1 illustrates a cross-section through a conventional short channel MIS transistor formed on an insulator. In Figure 1 the reference numerals 1, 2, 3, 4, 5, 6 and 7 indicate an insulating substrate of sapphire or silicon dioxide, a silicon layer, a source region, a drain region, a channel region, a gate insulating layer, and a gate electrode, respectively. In this specification, "channel region in the silicon layer" means the portion of the silicon layer 2 which lies under the gate insulating layer 6 and in which a channel is generated. The insulating substrate 1 is generally set on a metal stage (not shown) and grounded by using solder, e.g. Au-Sb solder. When the source region 3 is grounded, the drain region 4 is subjected to a drain voltage ($V_D$), and the gate electrode 7 is subjected to a gate voltage ($V_G$), we have discovered that equipotential lines are formed in the channel region as indicated with broken lines in Figure 1. As shown these equipotential lines in the channel region 5 have a large vertical component over most of the length of the channel. Accordingly it can be appreciated that variation of the drain voltage creates feedback influencing the channel, and the transconductance (gm) and the punchthrough voltage ($V_{PT}$) are lowered.

Referring now to Fig. 1, there is illustrated an embodiment of an MISFET on insulator of the present invention. The MIS transistor is formed on an insulating layer 11 consisting of a thin portion 12 and a thick portion 13. The MIS transistor comprises a source region 14, a drain region 15, a channel region 16, a gate insulating layer 17, and a gate electrode 18 and is formed on the insulating layer 11. This part of the MIS transistor is similar to that of the conventional MIS transistor illustrated in Fig. 1. A conductor layer 19 having a projecting portion 20 is formed under the insulating layer 11. As can be seen from Fig. 2, the thin portion 12 of the insulating layer 11 is under the channel region 16, namely, between the channel region 16 and the projecting portion 20 of the conductor layer 19.

The length of the channel to be generated (i.e., the length of the channel region 16 between the source and drain regions 14 and 15) is 2.0 μm or less.

It is preferable that the insulating layer 11 be made of silicon dioxide or silicon nitride and that the thickness of the thin portion 12 be from 30 to 100 nm and the thickness of the thick portion 13 be from 500 nm to 2.0 μm.

It is desirable that the conductor layer 19 be a substrate of high doped semiconductor (e.g. a silicon wafer having a low electrical resistance), metal (e.g., tungsten, molybdenum, tantalum, or aluminium), or graphite. It is possible to make the conductor layer from a substrate (e.g., of silicon, ceramic, glass or high-temperature resin) and a metal film made from tungsten, molybdenum, tantalum or aluminium formed on the substrate. In the case where aluminium or a high temperature resin is used, taking the melting point or the softening point into consideration, the MIS transistor should be produced without high temperature heat-treatment.

It is also possible that the conductor layer 19 be made of a single crystalline silicon substrate and the projecting portion 20 be a high doped region of it or be coated with a metal film. In this case, another MIS transistor can be built in the silicon substrate at a short distance from the source, drain, and channel regions 14, 15, and 16, thereby producing a three-dimensional semiconductor device.

It is preferable to form a field insulating layer 21 serving as an interdevice dielectric isolation, as illustrated in Fig. 2.

With the short channel MIS transistor (Fig. 2) according to the present invention, when the source region 14 and conductor layer 19 are grounded, the drain region is subjected to a drain voltage ($V_D$), and the gate electrode 18 is subjected to a gate voltage ($V_G$), equipotential lines indicated with broken lines in the channel region 16 and in the insulating layer 11 can be imagined as illustrated in Fig. 2. As seen in Fig. 2, since the projecting portion 20 which is grounded is under the channel region 16 and the portion 12 of the insulating layer 11 is thin, the equipotential lines on the channel region 16 run parallel to the gate electrode 18 in the main part and downward in the end part next to the drain region 15. The configuration of the equipotential lines in the short channel region 16 is similar to that of equipotential lines in a long channel region case. Accordingly the MIS transistor according to the present invention has a higher transconductance and punch-through voltage compared with the conventional MIS transistor illustrated in Fig. 1. Namely, the structure of the MIS transistor of the present invention prevents the reduction of the transconductance and the punch-through voltage caused by the short channel.

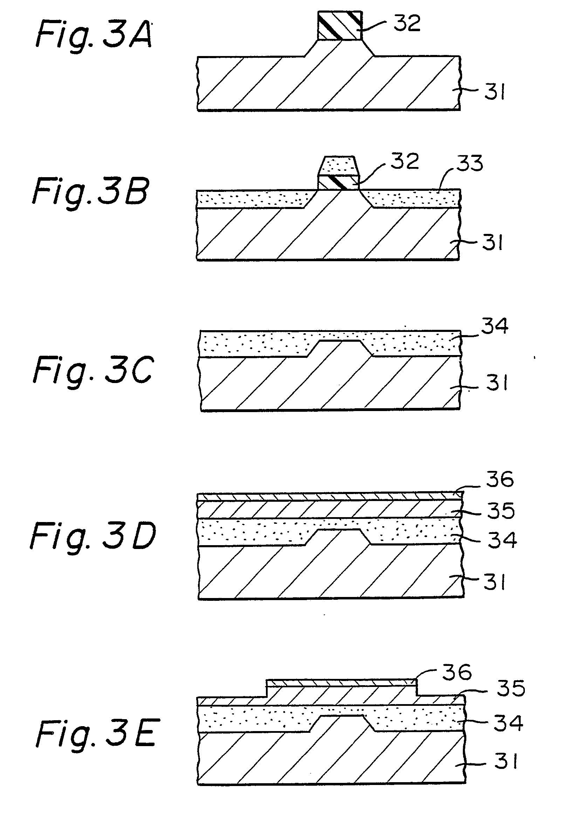

The short channel MIS transistor according to the present invention is produced, for example, in the manner described below in reference to Figs. 3A to 3H.

As illustrated in Fig. 3A, a high doped silicon wafer 31 having an electric resistance of e.g., 0.1 ohm · cm is used as a conductor layer. A photoresist layer 32 is formed on the silicon wafer 31, is exposed, and is developed, so as to cover a 2.0

μm or less wide portion of the silicon wafer 31. The uncovered portion of the silicon wafer 31 is then etched by a reactive ion etching process. The thickness of the etched portion of the silicon wafer 31 is approximately 1.0 μm.

As illustrated in Fig. 3B, a silicon dioxide layer 33 having a thickness of approximately 1.0 μm is formed on the silicon wafer 31 and on the remaining photoresist layer 32 by a chemical vapor deposition (CVD) process. The remaining photoresist layer 32 is then removed along with the silicon dioxide formed thereon.

As illustrated in Fig. 3C, another silicon dioxide layer having a thickness of from 30 to 100 nm is formed on the former silicon dioxide layer 33 and on the exposed portion of the silicon wafer 31 by a CVD process. Consequently a silicon dioxide layer 34 consisting of the former and latter silicon dioxide layers is obtained as an insulating layer. It is possible to form a silicon nitride layer, instead of the latter silicon dioxide layer, on the former silicon dioxide layer 33 and the exposed silicon wafer 31.

As illustrated in Fig. 3D, polycrystalline silicon layer 35 having a thickness of approximately 300 nm is formed on the silicon dioxide layer 34 by a pyrolysis process of silane ($SiH_4$) or by a physical vapor deposition (PVD) process. Then a silicon nitride ($Si_3N_4$) layer 36 having a thickness of approximately 100 nm is formed on the polycrystalline silicon layer 35 by a CVD method. The polycrystalline silicon layer 35 is doped with impurities, e.g., boron (P type). The silicon nitride layer 36 serves as an antireflecting film and as an anticontamination film, and smooths the surface of the single crystalline silicon layer, when single crystallization of polycrystalline silicon is carried out.

As illustrated in Fig. 3E, the silicon nitride layer 36 and the polycrystalline silicon layer 35 are selectively etched by a conventional photoetching process. Approximately half of the original thickness of the polycrystalline silicon layer 35 is removed at the etched portions.

As illustrated in Fig. 3F, the remaining half-thickness etched portions of the polycrystalline silicon layer 35 are thermally oxidized down to the silicon dioxide layer 34 to form a silicon dioxide portion 37 which surrounds the polycrystalline silicon island 38 and serves as interdevice dielectric isolation. Then the polycrystalline silicon island 38 is single crystallized by irradiation of a light beam, such as a laser, or of a particle beam, such as an electron beam. Namely, the polycrystalline silicon is laser annealed or electron beam annealed to form a single crystalline silicon island layer 39. For example, an argon gas continuous wave laser having an output of 10W, a scanning speed of 10 cm/sec, and a beam spot size of from 50 to 100 μm, may be irradiated in a 50% overlapping manner to change the polycrystalline silicon to a single crystalline silicon.

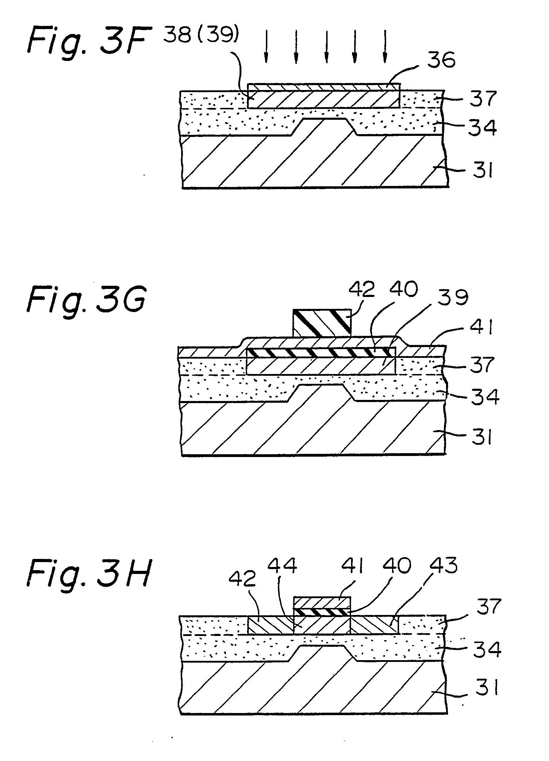

As illustrated in Fig. 3G, the silicon nitride layer 36 is removed, then the surface portion of the single crystalline layer 39 of P type is thermally oxidized to form a gate insulating layer 40 of silicon dioxide having a thickness of from 30 to 100 nm. A polycrystalline silicon layer 41 is formed, as a gate electrode, on the gate insulating layer 40 and on the field silicon oxide layer 37 by the pyrolysis process or the PVD process. Then, a photoresist layer is formed on the polycrystalline silicon layer 41, is exposed, and is developed. The remaining photoresist layer 42 having a width of 2.0 μm or less is located above the projecting portion of the silicon wafer 31.

As illustrated in Fig. 3H, the polycrystalline silicon layer 41 and the gate insulating layer 40 are selectively etched by a suitable etchant to form, under the remaining photoresist layer 42, a gate electrode 41 and a gate insulating layer portion 40. N type impurities, e.g., phosphorus, are introduced into the P type single crystalline silicon layer 39 by a thermal diffusion process or an ion-implantation process to form a source region 42 and a drain region 43. During the introduction of impurities, the gate electrode 41 and the gate insulating layer 40 serve as a mask. Thus it is possible to produce a short channel MIS transistor, with an N channel, comprising the gate electrode 41, the gate insulating layer 40, the source region 42, the drain region 43, and the channel region 44 being a portion of the single crystalline silicon layer 39.

Instead of a N-channel MIS transistor, it is possible to produce a P channel MIS transistor.

### Claims

1. A metal insulator semiconductor transistor comprising an insulating layer (11); a semiconductor layer which is formed on the insulating layer (11) and which comprises a source region (14), a drain region (15) and a channel region (16); a gate insulating layer (17) formed on the channel region (16); and a gate electrode (18) formed on the gate insulating layer; characterised in that a portion (12) of the insulating layer (11) lying beneath the channel region (16) is thinner than that (13) lying beneath the other regions, this thinner portion (12) contributing to the distribution of equipotential lines in the channel region (16) parallel to the gate electrode (18), and in that a conducting layer (19) is formed beneath the insulating layer (11).

2. A transistor according to claim 1, in which the thinner portion (12) of the insulating layer (11) has a thickness in a range from 30 to 100 nm and that the thicker portion (13) of the insulating layer (11) has a thickness in a range from 500 nm to 2.0 μm.

3. A transistor according to claim 1 or 2, in which the insulating layer (11) is made from silicon dioxide or silicon nitride.

4. A transistor according to any one of the preceding claims, in which the conducting layer (19) is made from a substrate of a highly doped semiconductor, metal, or graphite.

5. A transistor according to claim 1, 2 or 3 in which the conducting layer (19) comprises a substrate of silicon, ceramic, glass, or high-temperature resin and a film overlying the substrate and made from tungsten, molybdenum, tantalum or aluminium.

6. A transistor according to claim 1, in which the conducting layer (19) is made from a single crystal silicon substrate having a conductive portion under the thinner portion (12) of the insulating layer (11).

7. A transistor according to claim 6, in which the conductive portion is a highly doped region of the silicon substrate.

8. A transistor according to claim 6, in which the conductive portion is a metal film.

9. A transistor according to claim 6, 7 or 8, in which another metal insulator semiconductor transistor is formed in a portion of the silicon substrate and is located close to the source (14), drain (15) and channel regions (16).

### Revendications

1. Transistor à métal-isolant-semi-conducteurs comportant une couche isolante (11), une couche semi-conductrice qui est formée sur la couche isolante (11) et qui comprend une région de source (14), une région de drain (15) et une région de canal (16); une couche d'isolement de grille (17) formée sur la région de canal (16); et une électrode de grille (18) formée sur la couche d'isolement de grille; caractérisé en ce qu'une partie (12) de la couche isolante (11) située au-dessous de la région de canal (16) est plus mince que celle (13) située au-dessous des autres régions, cette partie plus mince (12) contribuant à la distribution de lignes équipotentielles dans la région de canal (16) parallèles à l'électrode de grille (18), et en ce qu'une couche conductrice (19) soit formée au-dessous de la couche isolante (11).

2. Transistor selon la revendication 1, dans lequel la partie plus mince (12) de la couche isolante (11) a une épaisseur dans une plage de 30 à 100 nm et la partie plus épaisse (13) de la couche isolante (11) a une épaisseur dans la plage de 500 nm à 2,0 μm.

3. Transistor selon la revendication 1 ou 2, dans lequel la couche isolante (11) est faite de bioxide de silicium ou nitrure de silicium.

4. Transistor selon l'une quelconque des revendications précédentes, dans lequel la couche isolante (19) est faite d'un substrat d'un semi-conducteur fortement dopé, d'un métal ou de graphite.

5. Transistor selon la revendication 1, 2 ou 3, dans lequel la couche conductrice (19) consiste en un substrat de silicium, de céramique, de verre ou de résine à haute température, et un pellicule recouvrant le substrat étant faite de tungstène, de molybdène, de tantale ou d'aluminium.

6. Transistor selon la revendication 1, dans lequel la couche conductrice (19) est faite d'un substrat de silicium mono-cristallin ayant une partie conductrice au-dessous de la partie plus mince (12) de la couche isolante (11).

7. Transistor selon la revendication 6, dans lequel la partie conductrice est un région fortement dopée du substrat de silicium.

8. Transistor selon la revendication 6, dans lequel la partie conductrice est une pellicule métallique.

9. Transistor selon la revendication 6, 7 ou 8, dans lequel un autre transistor à métal-isolant-semi-conducteur est formé dans une partie du substrat de silicium et se trouve près des régions de source (14) de drain (15) et de canal (16).

## Patentansprüche

1. Metallisolatorhalbleiter-Transistor, mit einer isolierenden Schicht (11); einer Halbleiterschicht, welche auf der isolierenden Schicht (11) gebildet ist und einen Sourcebereich (14), einen Drainbereich (15) und einen Kanalbereich (16) umfaßt; einer Gateisolierschicht (17), die auf dem Kanalbereich (16) gebildet ist; und einer Gateelektrode (18), die auf der Gateisolierschicht gebildet ist; dadurch gekennzeichnet daß ein Abschnitt (12) der isolierenden Schicht (11), der unter dem Kanalbereich (16) liegt, dünner als derjenige (13) ist, der unter den anderen Bereichen liegt, wobei dieser dünnere Abschnitt (12) zu der Verteilung der Äquipotentiallinien in dem Kanalbereich (16) parallel zu der Gateelektrode (18) beiträgt, und daß eine leitende Schicht (19) unter der isolierenden Schicht (11) gebildet ist.

2. Transistor nach Anspruch 1, bei welchem der dünnere Abschnitt (12) der isolierenden Schicht (11) eine Dicke im Bereich von 30 bis 100 nm hat, und daß der dickere Abschnitt (13) der isolierenden Schicht (11) eine Dicke im Bereich von 500 nm bis 2,0 μm hat.

3. Transistor nach Anspruch 1 oder 2, bei welchem die isolierende Schicht (11) aus Siliziumdioxid oder Siliziumnitrid gebildet ist.

4. Transistor nach einem der Vorhergehenden Ansprüche, bei welchem die leitende Schicht (19) aus einem Substrat aus einem hochdotierten Halbleiter, Metall oder Graphit hergestellt ist.

5. Transistor nach Anspruch 1, 2 oder 3, bei welchem die leitende Schicht (19) ein Substrat aus Silizium, Keramik, Glas oder Hochtemperaturharz und einem Film besteht, der über dem Substrat liegt, und aus Wolfram, Molybdän, Tantal oder Aluminium hergestellt ist.

6. Transistor nach Anspruch 1, bei welchem die leitende Schicht (19) aus einem einkristallinen Siliziumsubstrat hergestellt ist, welches eine leitenden Abschnitt unter dem dünneren Abschnitt (12) der isolierenden Schicht (11) hat.

7. Transistor nach Anspruch 6, bei welchem der leitende Abschnitt ein hochdotierter Bereich des Siliziumsubstrats ist.

8. Transistor nach Anspruch 6, bei welchem der leitende Abschnitt ein Metallfilm ist.

9. Transistor nach Anspruch 6, 7 oder 8, bei welchem ein anderer Metallisolatorhalbleiter-Transistor in einem Abschnitt des Siliziumsubstrats gebildet und nahe dem Source- (14), Drain- (15) und Kanalbereichen (16) angeordnet ist.

# *Fig. 1*

# *Fig. 2*

Fig. 3A

Fig. 3B

Fig. 3C

Fig. 3D

Fig. 3E

*Fig. 3F* 38(39)

36
37
34
31

*Fig. 3G*

42 40 39
41
37
34
31

*Fig. 3H*

42 44 41 40 43
37
34
31